Europäisches Patentamt

European Patent Office

Office européen des brevets

(11) Veröffentlichungsnummer: **0 241 744**
**A2**

## (12) EUROPÄISCHE PATENTANMELDUNG

(21) Anmeldenummer: 87104025.9

(22) Anmeldetag: 19.03.87

(51) Int. Cl.4: **H01L 21/208** , H01L 21/82

(30) Priorität: 16.04.86 DE 3612828

(43) Veröffentlichungstag der Anmeldung:
21.10.87 Patentblatt 87/43

(84) Benannte Vertragsstaaten:
DE FR GB IT

(71) Anmelder: **Siemens Aktiengesellschaft Berlin
und München**
**Wittelsbacherplatz 2**
**D-8000 München 2(DE)**

(72) Erfinder: **Jäntsch, Ottomar, Dr. rer. nat.**
**Defreggerstrasse 12**
**D-8012 Ottobrunn(DE)**

(54) **Flüssigphasenepitaxie-Verfahren, vorzugsweise zur Herstellung dreidimensionaler Halbleiterstrukturen.**

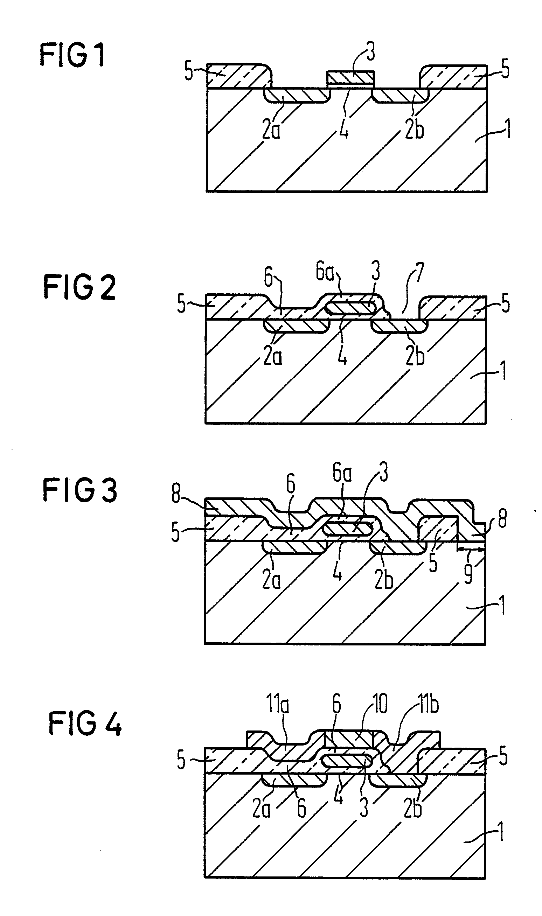

(57) Bei einem Flüssigphasenepitaxie-Verfahren wird zur Herstellung der die Halbleiterstrukturen (10, 11a, 11b) enthaltenden epitaktisch abzuscheidenden Siliziumschicht (8) als Lösungsmittel eine Schmelze aus einem Metall verwendet, welches mit Silizium gesättigte Lösungen unterhalb von 900°C bildet und in den Schichten keine Dotierung erzeugt, die einer Konzentration von größer $10^{17}$ Dotieratome/cm³ entspricht. Vorzugsweise wird wegen des bei 370°C liegenden Schmelzpunktes des Eutektikums Gold/Silizium eine Goldschmelze verwendet. Durch die Erfindung ist die Möglichkeit gegeben, die Flüssigphasenepitaxie bei sehr niedrigen Temperaturen durchzuführen und auf diese Weise einkristalline Siliziumschichten (8) auf mit Isolationsschichten (5, 6) versehenen Substraten (1, 2, 3) zu erzeugen, wie sie für die dreidimensionale Integration in der Mikroelektronik erforderlich sind. Figur 4

FIG 4

EP 0 241 744 A2

## Flüssigphasenepitaxie-Verfahre, vorzugsweise zur Herstellung dreidimensionaler Halbleiterstrukturen

Die Erfindung betrifft ein Flüssigphasenepitaxie-Verfahren, vorzugsweise zur Herstellung dreidimensionaler Halbleiterstrukturen auf mit Isolationsschichten versehenen Siliziumsubstraten, bei dem für die Herstellung der die Halbleiterstrukturen enthaltenden epitaktisch abzuscheidenden, homogen dotierten, aus Silizium bestehenden Schichten als Lösungsmittel eine Metallschmelze verwendet wird.

In der Mikroelektronik ist es bei der dreidimensionalen Integration von Bauelementstrukturen erforderlich, mehrere Siliziumschichten isoliert übereinander aufzubringen. In diesen Schichten werden dann aktive und passive Bauelemente, wie z.B. Dünnfilmtransistoren, Bipolartransistoren und Kondensatoren, mit den in der Mikroelektronik üblichen Verfahrensschritten erzeugt.

Bisher wurden die Siliziumschichten auf Siliziumdioxidschichten durch Abscheidung aus der Gasphase erzeugt. Diese Schichten sind zunächst polykristallin. Mit Lasern, Graphitheizern oder intensiven Strahlungsquellen lassen sich die polykristallinen Schichten aufschmelzen und von einem Fenster in der Oxidschicht ausgehend zu einkristallinen Schichten rekristallisieren. Das Siliziumsubstrat im Fenster wirkt dabei als Keim und bestimmt die Orientierung der einkristallinen Schicht (lateral seeding). Ein Nachteil dieser Verfahren ist, daß bei der Rekristallisation das Siliziumsubstrat in unzulässiger Weise erwärmt wird und dabei bereits hergestellte Bauelemente Schaden erleiden.

Ein solches Verfahren ist beispielsweise aus der europäischen Patentanmeldung 0 117 339 bekannt.

Aus der DE-AS-24 45 146 ist bekannt, daß sich mit Flüssigphasenepitaxie dünne dotierte Einkristallschichten abscheiden lassen. Dabei wird das zu beschichtende Substrat durch Zentrifugalkraft mit einer das Schichtmaterial enthaltenden Metallschmelze in Kontakt gebracht. Als Lösungsmittel des Siliziums werden die Metalle: Gallium, Wismuth, Indium, Antimon und Zinn verwendet.

Es ist ferner auf der ESSDERC 85 von Appel, Bauser, Bender, Käß, Strunk, Vogel und Warth berichtet worden, daß man lateral über SiO₂ gewachsene Schichten mit homogener Dotierung herstellen kann. Solche durch Flüssigphasenepitaxie hergestellte Siliziumschichten lassen sich, wie aus der deutschen Patentanmeldung P 36 04 260.9 zu entnehmen ist, zur Herstellung dreidimensionaler Bauelementstrukturen verwenden. Das in dieser Patentanmeldung und auch in der Zeitschrift: Physica 129B (1985), North-Holland, S. 161-165 bevorzugt für die Flüssigphasenepitaxie vorgeschlagene Gallium als Lösungsmittel für das Silizium erzeugt eine Konzentration der Dotierung, die größer als $10^{18}/cm^3$ ist und deshalb als Grunddotierung für die dreidimensional aufgebauten Schichten einer integrierten Halbleiterschaltung nicht geeignet ist.

Aufgabe der Erfindung ist es, ein geeignetes Metall als Lösungsmittel für die Flüssigphasenepitaxie anzugeben, welches den Prozeß bei relativ niedrigen Temperaturen erlaubt und mit dessen Hilfe Siliziumschichten erzeugt werden können, in denen reproduzierbar Bauelementstrukturen mit optimalen Parametern für dreidimensionale Integration herstellbar sind.

Diese Aufgabe wird bei einem Verfahren der eingangs genannten Art dadurch gelöst, daß als Lösungsmittel Metalle verwendet werden, die sich durch folgende Eigenschaften auszeichnen:

a) ihre mit Silizium gesättigten Lösungen sind bei Temperaturen unterhalb von 900°C flüssig,

b) sie erzeugen in den Schichten keine Dotierung, die einer Konzentration von $10^{17}$ Dotieratomen/cm³ entspricht, und

c) sie sind keine Silizidbildner.

Es liegt in Rahmen der Erfindung, daß als Metallschmelze eine Goldschmelze verwendet wird. Der Schmelzpunkt des Gold-Silizium-Eutektikums liegt sehr niedrig, bei etwa 370°C; (siehe "Constitution of Binary Alloys" von Hansen (1958), Verlag Mc Graw Hill Book Comp., Seite 232) die Flüssigphasenepitaxie ist deshalb bei niedrigen Temperaturen möglich. Gemäß einem Ausführungsbeispiel nach der Lehre der Erfindung wird der Anteil von Silizium in der Silizium-Goldschmelze auf größer 31 Atom%, aber kleiner als 49 Atom%, vorzugsweise auf einen Bereich zwischen 32 und 38 Atom% eingestellt.

Bei der Auskristallisation des Silizium aus der elektrischen Gold/Siliziumschmelze bleibt ein gewisser Rest des Goldes im Silizium. Diese Löslichkeit ist für Gold im Silizium bei tiefen Temperaturen sehr niedrig. Sie liegt z.B. bei 600°C unter $10^{13}$ und bei 500°C unter $10^{12}/cm^3$. Außerdem erzeugt Gold tiefe Störstellen und keine flachen an den Bandkanten, die bei Raumtemperatur vollständig ionisiert sind (Gold wird z.B. in schnelle Thyristoren bewußt eindiffundiert). Sollten die geringen Goldkonzentrationen in der Siliziumschicht stören, so lassen sich diese in bekannter Weise durch Getterprozesse entfernen.

Als Lösungsmittel kann auch Silber verwendet werden. ·

Doch liegt dessen Schmelzpunkt höher als die des Gold-Silizium-Eutektikums (siehe Buch von Hanser (1958), Seite 51).

Wichtig beim erfindungsgemäßen Verfahren ist, daß die Lösungsmittel keine Dotierung über $10^{17}/cm^3$ erzeugen (bevorzugter Wert: eine Dotierung unter $10^{14}$ Atome/$cm^3$), daß die keine Silizide bilden, und daß ihre mit Silizium gesättigten Lösungen flüssig sind bei Temperaturen, die unter den normalen Herstelltemperaturen von integrierten Schaltungen liegen (900°C).

Weitere Einzelheiten der Erfindung, insbesondere über die Durchführung der Flüssigphasenepitaxie, werden nachfolgend anhand der Figuren 1 bis 4 noch näher erläutert. Dabei zeigen die Figuren im Schnittbild die erfindungswesentlichen Verfahrensschritte zur Herstellung einer einfachen dreidimensionalen Struktur im Form eines CMOS-Inverters bis zur Metallisierung. Die Vorrichtung zur Durchführung des Verfahrens ist aus dem Bericht von Käß, Warth, Strunk und Bauser aus der Zeitschrift Physica 129B, North Holland, (1985) Seiten 161-165 zu entnehmen.

Gleiche Teile sind in den Figuren mit gleichen Bezugszeichen bezeichnet.

Figur 1 zeigt die Anordnung nach dem Erzeugen der n-dotierten Source/Drain-Zonen 2a, 2b für den n-Kanaltransistor in einem p-dotierten Siliziumsubstrat 1 und nach dem Strukturieren der aus zum Beispiel n-dotiertem Polysilizium bestehenden Gate-Elektrode 3 der n-Kanaltransistoren. Dabei ist die Gate-Elektrode 3 vom Siliziumsubstrat 1 durch die Gateoxidschicht 4 getrennt. Mit dem Bezugszeichen 5 sind die, die einzelnen MOS-Inverter (n-Kanal-und p-Kanal-Transistoren) trennenden Feldoxidbereiche bezeichnet, die vor der Erzeugung der Transistorstrukturen 2, 3, 4 auf dem Siliziumsubstrat 1, zum Beispiel nach dem sogenannten LOCOS-Verfahren erzeugt werden.

Figur 2: Auf die den n-Kanal-Typ-Transistor enthaltende Anordnung 1, 2, 3, 4, 5 wird nun eine Siliziumdioxidschicht 6 aufgebracht, die im Bereich der Gateoberfläche 3 das Gateoxid 6a für den später durch Flüssigphasenepitaxie zu erzeugenden p-Kanal-Transistor darstellt. Die Figur zeigt die Anordnung nach dem Aufbringen der Oxidschicht 6 und nach dem Öffnen des Kontaktloches 7 zu dem diffundierten Bereich 2b. Wie aus der Figur zu entnehmen ist, ist durch das Aufbringen der Oxidschicht 6 eine weitgehende Planarisierung der Anordnung eingetreten, da die Oxidschicht 6 die Gruben über dem n-Kanal-Transistor vollkommen auffüllt.

Figur 3: Nun wird der Verfahrensschritt der Flüssigphasenepitaxie mit einer Silizium-Goldschmelze durchgeführt, wobei die Silizium-Goldschmelze in einer Zusammensetzung verwendet wird, die über dem Eutektikum Silizium/ Gold (370°C) liegt. Das Verhältnis der Atomprozente der Lösung beträgt dabei Silizium : Gold = 35 : 65. Es entsteht mittels der bereits in der Zeitschrift "Physica" zitierten Vorrichtung die einkristalline Siliziumschicht 8, wobei die diffundierte Zone 2b und (gegebenenfalls auch) ein außerhalb des n-Kanal-Transistorbereiches durch eine im Feldoxidbereich 5 durchgeführte Ätzung geöffneter Bereich (siehe Doppelpfeil 9) auf dem Substrat als Keimbereiche dienen (lateral seeding).

Figur 4: In der ganzflächigen durch Flüssigphasenepitaxie mit Gold als Lösungsmittel aufgebrachten einkristallinen Siliziumschicht 8 werden nun nacheinander die aktiven Zonen des p-Kanaltyps erzeugt, wobei zunächst durch Implantation mit n-dotierenden Ionen (Arsen) der n-dotierte Bereich 10 als Gate und nach dem Maskieren dieses Bereiches 10 durch Bor-Ionenimplantation die p-dotierten Zonen 11a, 11b des p-Kanal-Transistors erzeugt werden.

Die Kontaktierung und Metallisierung (Masseanschluß an 2a, $V_{cc}$ an 11a, Eingang an 3 und Ausgang an 11b) erfolgt nach der Strukturierung des p-Kanal-Transistors 10, 11a, 11b in bekannter Weise.

## Ansprüche

1. Flüssigphasenepitaxie-Verfahren, vorzugsweise zur Herstellung dreidimensionaler Halbleiterstrukturen auf mit Isolationsschichten (5, 6, 6a) versehenen Siliziumsubstraten (1, 2, 3) bei dem für die Herstellung der die Halbleiterstrukturen (10, 11a, 11b) enthaltenden epitaktisch abzuscheidenden, homogen dotierten, aus Silizium bestehenden Schichten (8) als Lösungsmittel eine Metallschmelze verwendet wird, **dadurch gekennzeichnet,** daß als Lösungsmittel Metalle verwendet werden, die sich durch folgende Eigenschaften auszeichnen:

a) ihre mit Silizium gesättigten Lösungen sind bei Temperaturen unterhalb von 900°C flüssig,

b) sie erzeugen in den Schichten (8) keine Dotierung, die einer Konzentration von größer als $10^{17}$ Dotieratome/$cm^3$ entspricht und

c) sie sind keine Silizidbildner.

2. Flüssigphasenepitaxie-Verfahren nach Anspruch 1, **dadurch gekennzeichnet,** daß als Metallschmelze eine Goldschmelze verwendet wird.

3. Flüssigphasenepitaxie-Verfahren nach Anspruch 2, **dadurch gekennzeichnet,** daß der Anteil von Silizium in der Silizium-Goldschmelze auf größer 31 Atom%, aber kleiner als 49 Atom%, eingestellt wird.

4. Flüssigphasenepitaxie-Verfahren nach Anspruch 2 oder 3, **dadurch gekennzeichnet,** daß der Anteil von Silizium in der Silizium-Goldschmelze auf einen Bereich zwischen 32 und 38% Atom eingestellt wird.

5. Flüssigphasenepitaxie-Verfahren nach einem der Ansprüche 1 bis 4, **dadurch gekennzeichnet,** daß die Grunddotierung der jeweiligen Schichten (8) auf eine Konzentration unter $10^{14}$ Dotieratome/cm³ eingestellt wird.

6. Flüssigphasenepitaxie-Verfahren nach einem der Ansprüche 1 bis 5, **dadurch gekennzeichnet,** daß als Metallschmelze eine Silberschmelze verwendet wird.

7. Flüssigphasenepitaxie-Verfahren nach Anspruch 6, **dadurch gekennzeichnet,** daß der Anteil von Silizium in der Silizium-Silberschmelze auf einen Bereich zwischen 15.4 und 16 Atom% eingestellt wird.

FIG 1

FIG 2

FIG 3

FIG 4